# FASCICULE DE BREVET EUROPEEN

(11) **EP 1 597 601 B1**
(45) Date de publication et mention de la délivrance du brevet: **06.06.2007**
(21) Numéro de dépôt: 04713926.6
(22) Date de dépôt: 24.02.2004
(51) Int. Cl.: G01R 29/08

(54) **PROCEDE ET SYSTEME POUR MESURER UN DEBIT D'ABSORPTION SPECIFIQUE (DAS)**
METHODE UND SYSTEM ZUR MESSUNG DER SPEZIFISCHEN ABSORBTIONSRATE
METHOD AND SYSTEM FOR MEASURING A SPECIFIC ABSORPTION RATE (SAR)

(30) Priorité: 27.02.2003 FR 0302441
(43) Date de publication de la demande: 23.11.2005
(73) Titulaire: Supelec, 91192 Gif sur Yvette Cédex (FR)
(72) Inventeur: MERCKEL, Olivier, F-91440 Bures sur Yvette (FR); BOLOMEY, Jean-Charles, F-75013 Paris (FR)
(74) Mandataire: Pontet, Bernard
(86) Numéro de dépôt international: PCT/FR2004/000409
(87) Numéro de publication internationale: WO 2004/079299

(56) Documents cités:
- EP-A- 1 070 966
- WO-A-01/86311
- US-B1- 6 525 657
- A. LAISNE, R. GILLARD, G. PITON: "Une Transformée Champ Proche - Champ Proche Multirésolution pour la MR / FDTD" 12ÈME JOURN¹ES NATIONALES MICROONDES, 18 mai 2001 (2001-05-18), XP002301520 POITIERS

## Description

La présente invention se rapporte à un procédé et un système pour mesurer un Débit d'Absorption Spécifique DAS dans un fantôme (enveloppe rigide remplie d'un liquide) reconstituant les propriétés diélectriques d'un tissu biologique homogène, ce fantôme étant exposé à une émission micro-onde provenant d'une antenne.

Elle trouve une application particulièrement intéressante, mais non exclusivement, dans la dosimétrie électromagnétique pour la caractérisation des téléphones mobiles.

La dosimétrie électromagnétique a pour objectif la détermination de la puissance dissipée dans des milieux absorbants, tels que, par exemple, les tissus biologiques. Elle revêt donc une grande importance dans le contexte du développement des communications cellulaires. Ce type de communications suscite en effet des interrogations quant à de possibles effets de l'exposition aux rayonnements électromagnétiques sur la santé. Ces effets peuvent être d'ordres thermique et athermique. Alors que les effets athermiques font l'objet de nombreuses spéculations, les effets thermiques sont bien contrôlés et pris en compte dans les normes. Celles en vigueur pour les téléphones portables visent à limiter le niveau de puissance dissipée dans la tête de l'usager. Pratiquement, c'est la densité de puissance dissipée par unité de masse de tissu biologique, le DAS en français (Débit d'Absorption Spécifique) ou le SAR en anglais ("Specific Absorption Rate"), qui est prise en compte. La recommandation européenne 1999/519/EC et le décret français n° 2002-775 du 3 mai 2002 fixent ainsi la valeur maximale du DAS intégré dans 10g de tissu à 2W/kg, alors que, pour la norme américaine ANSI/IEEE C95.1/1991, elle est de 1,6 W/kg dans un volume de 1g.

La norme européenne prEN50361 précise le protocole de mesure du SAR. Une sonde électrique isotrope est déplacée dans un fantôme, récipient dont la forme reproduit celle d'une tête et qui est rempli d'un liquide dont les propriétés électromagnétiques sont équivalentes à celles des tissus biologiques constituant la tête. Les caractéristiques diélectriques de ce liquide ont été déterminées par comparaison des SAR obtenus par modélisation numérique, d'une part, avec un fantôme homogène et, d'autre part, avec une tête "réelle" discrétisée. Le pas d'échantillonnage du champ électrique dans le fantôme est fixé à quelques millimètres, dans un volume exploré de quelques centimètres cubes. Le SAR moyenné dans un cube de 10g ou 1g, selon la norme, se déduit des valeurs mesurées par inter-/extrapolation.

Selon la norme, pour un même téléphone, les mesures doivent être répétées pour deux positions par rapport au fantôme et pour trois fréquences autour de 900 MHz et 1800 MHz. Plus précisément, le téléphone portable, en émission à puissance maximale, est placé. à proximité du fantôme suivant douze configurations nominales d'utilisation. Au total, il faut entre une demi-journée et une journée complète pour tester complètement un téléphone.

À côté de cet aspect strictement normatif, d'autres besoins se font évidemment sentir en terme de dosimétrie. Par exemple, lors du développement et de la mise au point de nouvelles antennes, il est nécessaire d'obtenir avec un maximum de rapidité des informations relatives au SAR, de la même façon que sont pratiquées les mesures d'adaptation d'impédance, de diagrammes de rayonnement, de puissance rayonnée et d'efficacité de rayonnement. De même, avant de lancer une mesure normative lourde, peut-il être utile d'obtenir rapidement une première information sur la valeur du SAR. Enfin, il est raisonnable d'envisager l'évolution des normes par l'amélioration de leur représentativité et de leurs conditions de mise en oeuvre.

A côté des systèmes de mesure normatifs, on connaît des systèmes de mesure du SAR tels que celui décrit dans le document WO 0004399. Ce document divulgue un concept général de mesure du SAR dans lequel une sonde est placée à l'intérieur d'un fantôme sphérique. Le téléphone portable est placé contre le fantôme selon plusieurs positions jusqu'à obtenir un maximum du signal généré par la sonde.

Le document US 5 610 519 décrit une sonde comportant deux bobines orthogonales permettant de distinguer le champ magnétique émis par l'antenne de celui réfléchi par les parois du fantôme.

Le document EP 1 070 966 décrit un dispositif de mesure du SAR dans un fantôme exposé à une emission micro-onde provenant d'une antenne. Ce dispositif comprend des moyens de mesure du champ électrique en amplitude et en phase, pour une pluralité de points de mesure s'inscrivant sur la surface du dit fantôme, et des moyens de calcul du champ électrique dans le volume du dit fantômes à partir de ces valeurs mesurées à la surface.

Le document US 6 525 657 décrit un dispositif de mesure du SAR dans un espace simulant le tissue humain. Une pluralité de capteur de mesure du champ électrique sont disposés à l'intérieur de l'espace simulant le tissu humain afin de mesurer l'influence des ondes radio-fréquences.

D'une façon générale, les systèmes de l'art antérieur proposent des solutions lentes et parfois compliquées à mettre en oeuvre dans la mesure où il est communément admis que les phénomènes physiques, en particulier électromagnétiques, à l'intérieur du fantôme sont extrêmement complexes et les techniques classiques de mesure des champs électromagnétiques en espace libre n'y sont que difficilement directement applicables.

La présente invention a pour but de proposer un procédé pour mesurer le SAR avec précision tout en réduisant considérablement le temps de mesure, jusqu'à atteindre le temps réel.

Un autre but de l'invention est de proposer un procédé simple à mettre en oeuvre, car ne nécessitant pas nécessairement un déplacement de la sonde de mesure.

On atteint au moins l'un des objectifs précités avec un procédé pour mesurer un Débit d'Absorption Spécifique DAS dans un fantôme rempli d'un liquide reconstituant les propriétés diélectriques d'un tissu biologique, ce fantôme étant exposé à une émission micro-onde provenant d'une antenne. Selon l'invention :
- on mesure le champ électrique (par exemple 2 composantes) en amplitude et en phase à l'intérieur du fantôme, pour une pluralité de points s'inscrivant sur une surface donnée définie dans une zone de champ proche de concentration dudit champ électrique;
- on réalise une transformation champ proche-champ proche à partir des données mesurées sur cette surface de façon à déterminer le champ électrique dans le volume à l'intérieur du fantôme; et
- on calcule la valeur du DAS, notamment le DAS local et moyenné dans une masse de 10g ou 1g, selon la norme.

Le fait de mesurer d'abord le champ électrique sur une seule surface, qui est de préférence un plan parallèle à la paroi du fantôme d'où provient le signal micro-onde, puis d'utiliser une transformation champ proche-champ proche pour déterminer le champ dans le volume interne au fantôme, va à l'encontre des préjugés généralement admis selon lesquels une telle technique de champ proche, normalement utilisée en espace libre ne peut pas être directement appliquée ici car :
- on n'est pas en espace libre homogène, mais dans une géométrie confinée,
- on effectue, généralement, des transformations champ proche-champ lointain permettant d'obtenir le champ rayonné à grande distance et non le champ proche nécessaire au calcul du DAS,
- on réalise ici des mesures dans un milieu à perte, et
- la présence d'ondes évanescentes au voisinage de la paroi du fantôme risquerait, *a priori,* de fausser considérablement les mesures, d'où un calcul erroné du DAS là, précisément, où ce DAS devrait être maximum.

Cependant, des études menées sur la répartition du champ électrique à l'intérieur du fantôme ont montré que le champ était fortement concentré dans une zone à l'intérieur du fantôme proche de la paroi exposée de telle sorte que les bords latéraux du fantôme interviennent peu.

Deux méthodes principales existent pour effectuer la transformation champ proche-champ lointain ou champ proche-champ proche : la méthode de développement modal (coordonnées planes, cylindriques ou sphériques...) et la méthode des sources équivalentes.

La géométrie plane, ou quasi-plane, de la plupart des fantômes au voisinage de l'antenne testée, ainsi que la facilité de réalisation d'un réseau de sondes plan et la simplicité de l'algorithme de transformation du champ proche en coordonnées planes, a conduit au choix de la première méthode pour la reconstruction du champ: le développement en sommes d'ondes planes. On peut trouver les fondements théoriques de cette méthode bien connue dans CLEMMOW P. C., « *The plane wave spectrum representation of electromagnetic fields* », Pergamon Press, 1966, par exemple, ainsi que le principe de sa mise en oeuvre pratique pour les mesures d'antennes (D. SLATER, *« Near Field Antenna Measurements* », Artech House, Boston, 1991).

Cependant, à la différence des applications traditionnelles de mesure d'antennes en champ proche, on s'intéresse ici à la mesure du champ proche et à sa reconstruction dans un milieu à pertes, dans lequel le vecteur d'onde est complexe, de part et d'autre du plan de mesure, et non pas en champ lointain.

La reconstruction spectrale permet, à partir d'un unique plan de mesure du champ électrique, de calculer le champ dans des plans plus ou moins profonds, par propagation ou rétro-propagation des ondes à partir du plan de mesure, pour ensuite en déduire par exemple le SAR local et moyenné dans 10g ou 1g dans le fantôme.

Selon une caractéristique avantageuse de l'invention, on mesure le champ électrique en utilisant au moins une sonde apte à mesurer deux composantes tangentielles, à la surface de mesure, du champ électrique en chaque point de mesure; la composante normale étant déduite par calcul à partir des deux composantes tangentielles.

Contrairement à l'art antérieur dans lequel la méthode dosimétrique classique repose sur la mesure de la valeur quadratique des trois composantes du champ, le procédé selon l'invention propose la mesure de deux composantes du champ électrique, mais en amplitude et en phase.

Le champ proche mesuré dans un plan arbitraire à quelque distance de la paroi, dans le liquide du fantôme, peut s'exprimer comme une combinaison linéaire d'ondes planes. En particulier, le choix d'une surface de mesure de géométrie plane peut se justifier par le caractère directif et limité en extension du rayonnement dans le fantôme. En effet, on considère que le champ est concentré dans un faible espace, réduisant les risques d'erreur de troncature. Par ailleurs, les interfaces des fantômes sont en général planes (fantômes génériques) ou quasi-planes (fantômes normatifs).

A partir de la connaissance des spectres d'ondes planes des deux composantes tangentielles du champ, on peut reconstruire le spectre d'ondes planes de la composante normale (calcul classique que l'on pourra trouver par exemple dans E. ROUBINE et J.Ch. BOLOMEY, *« Antennes, tome I, p. 49 »,* Masson, 1978). On déduit, par transformée de Fourier, la composante normale du champ électrique dans un plan quelconque parallèle au plan de mesure.

Les reconstructions du champ sont accessibles dans des plans plus proches ou plus lointains de la source par rapport au plan de mesure (respectivement rétro-propagation ou propagation), à condition de rester dans le fantôme, c'est-à-dire dans le même milieu (sans source) que celui de la mesure.

Avantageusement, on utilise les algorithmes de transformées de Fourier rapides (FFT : *Fast Fourier Transform)* pour calculer les spectres d'ondes planes et les champs reconstruits, tout en considérant les pertes dans le liquide. Ces calculs nécessitent la connaissance de la fréquence d'émission de l'antenne, la position en z du plan de mesure, la conductivité et la permittivité du liquide remplissant le fantôme.

Une fois le champ électrique reconstruit dans toute la partie utile du fantôme, le SAR local peut être calculé, puis le SAR moyenné dans 1 g ou 10 g.

Selon un mode de mise en oeuvre de l'invention, au cours de la transformation champ proche-champ proche, on réalise un filtrage, spectral ou spatial par exemple, de façon à limiter des effets de remontée de bruit dus aux ondes évanescentes. Ceci a pour avantage d'améliorer la qualité de la rétro-propagation du champ. Selon l'invention, le filtrage peut être réalisé avant et/ou après la rétro-propagation.

On peut par exemple réaliser un filtrage spectral de type circulaire consistant en fait à éliminer les valeurs du spectre à (rétro)propager situées au-delà d'un cercle de rayon donné. En ajustant la valeur du rayon du cercle, il est possible de prendre en compte une partie plus ou moins importante du domaine évanescent. Après une étude numérique du comportement des ondes évanescentes dans le milieu à pertes, il est apparu que le rayon du cercle à prendre en compte peut être simplement déterminé comme celui du domaine visible du milieu sans perte correspondant.

Pour atténuer les effets de bord résultant de la coupure brutale du spectre, semblables à ceux dus à la troncature spatiale mais dans le domaine spectral, on peut adopter une fenêtre de filtrage de Tukey HARRIS F. J., « *On the use of windows for harmonic analysis with the Discrete Fourier Transform* », Proceedings of the IEEE, vol. 66, n° 1, p. 51-83, 1978.

On peut également réaliser un filtrage au moyen d'une détection de contours, qui vise à ne conserver que la partie centrale du spectre d'ondes planes à filtrer, par la détection du premier minimum local du spectre autour de sa valeur maximale.

Bien que le procédé puisse s'appliquer à une sonde unique déplacée mécaniquement, selon un mode de mise en oeuvre avantageux de l'invention, on mesure le champ électrique au moyen d'une pluralité de sondes disposées en réseau de telle sorte qu'on évite le déplacement mécanique de la sonde. On réalise ainsi des mesures rapides, « en temps réel ». Compte tenu de la rapidité des calculs nécessaires à la transformation du champ proche mesuré et au calcul du DAS moyenné, obtenu au besoin par corrélation avec la valeur du DAS maximum local, on peut visualiser en temps réel sur un écran de visualisation la valeur du champ électrique, du DAS et celle du DAS moyenné dans 1g et 10g selon la puissance de calcul disponible.

Par temps réel, on entend une cadence de plus d'une dizaine de mesures par seconde.

De préférence, on utilise des sondes bipolarisées de façon à mesurer deux composantes tangentielles, à ladite surface, du champ électrique en chaque point de mesure et en déduire l'amplitude et la phase de chacune d'elles; la composante normale étant déduite par calcul à partir des deux composantes tangentielles.

Par ailleurs, dans le cas de téléphones portables, les sondes grâce auxquelles on mesure le champ électrique se situent sensiblement à une distance de quinze à vingt-cinq millimètres de la paroi interne exposée du fantôme, du côté d'où provient le signal micro-onde de l'antenne, afin de minimiser les interactions entre les sondes et la paroi.

Suivant un autre aspect de l'invention, il est proposé un système pour mesurer un Débit d'Absorption Spécifique DAS dans un fantôme rempli d'un liquide reconstituant les propriétés diélectriques d'un tissu biologique, ce fantôme étant exposé à une émission micro-onde provenant d'une antenne; ce système est caractérisé en ce qu'il comprend :
- des moyens pour mesurer le champ électrique en amplitude et en phase, à l'intérieur du fantôme, pour une pluralité de points s'inscrivant sur une surface donnée définie dans une zone de champ proche de concentration dudit champ électrique;
- des moyens de traitement pour réaliser une transformation champ proche-champ proche à partir des données mesurées sur cette surface de façon à déterminer le champ électrique dans le volume à l'intérieur du fantôme, et pour calculer la valeur du DAS.

Selon l'invention, chaque sonde bipolarisée comporte deux dipôles électriques orthogonaux constitués par quatre pistes distinctes conductrices coplanaires fixées en forme de croix sur un substrat mince et rigide.

Le réseau de sonde peut être un réseau plan disposé parallèlement à la paroi du fantôme d'où provient le signal micro-onde. Il peut aussi être un réseau dont la forme « imite » la forme d'un côté du fantôme exposé au signal micro-onde.

Avantageusement, les moyens de traitement peuvent comprendre :
- un multiplexeur pour piloter successivement chaque sonde,
- un analyseur de réseaux (ou un oscilloscope) pour recevoir les signaux micro-ondes provenant des sondes, et
- un module de traitement tel qu'un micro-ordinateur pour réaliser la transformation champ proche-champ proche, calculer le DAS et piloter le multiplexeur et l'analyseur de réseau(ou l'oscilloscope).

Selon une caractéristique de l'invention, le multiplexeur peut comprendre, disposés en cascade, et pour une rangée de six sondes:
- un premier commutateur (par exemple de type SP6T) pour sélectionner successivement les deux polarisations horizontale et verticale des sondes, dont les entrées sont reliées à deux symétriseurs,
- quatre autres commutateurs (par exemple de type SP6T) pour sélectionner l'une des six sondes. Chaque commutateur est affecté à l'une des quatre pistes des sondes. Chaque entrée de chaque commutateur est donc relié à chacune des six sondes. Les quatre sorties des commutateurs sont reliées deux à deux aux entrées des symétriseurs.

Selon une variante de l'invention, le multiplexeur peut être intégré sur un circuit électronique composé de commutateurs microondes intégrés montés en surface (CMS), voire en circuits intégrés microondes.

A titre d'exemples, dans le cas de la mesure du DAS de téléphones portables, à 900 MHz et 1800 MHz notamment, les sondes peuvent être constituées en un réseau plan carré de côté sensiblement égal à soixante-dix millimètres; la distance entre deux sondes peut être au plus égale à la moitié de la longueur d'onde du signal micro-onde émis dans le liquide du fantôme; la distance entre le réseau de sondes et la paroi du fantôme exposée au signal micro-onde peut être typiquement sensiblement comprise entre quinze millimètres et vingt-cinq millimètres, selon la bande de fréquences considérée; et les sondes peuvent être constituées en un réseau de trente-six sondes.

Suivant une variante avantageuse de l'invention, les moyens de mesure peuvent comprendre un réseau de dipôles associé à un collecteur selon le principe de la méthode de diffusion modulée (BOLOMEY J.CH., GARDIOL F. *« Engineering applications of the modulated scatterer technique* » Artech House, Boston, 2001), chaque dipôle étant chargé par une diode ou à un élément photosensible qui, lorsqu'elle est modulée, diffuse un signal proportionnel au champ électrique à l'emplacement du dipôle associé. Le signal diffusé est capté par le collecteur. La modulation successive des différentes diodes permet de mesurer le champ à l'emplacement des dipôles, sans nécessiter de multiplexage microonde.

D'autres avantages et caractéristiques de l'invention apparaîtront à l'examen de la description détaillée d'un mode de mise en oeuvre nullement limitatif, et des dessins annexés, sur lesquels:
La figure 1 est une vue schématique simplifiée de l'ensemble du système selon l'invention;
La figure 2 est une vue de dessous d'un réseau de sonde pour la mesure du champ électrique selon l'invention;
La figure 3 est un organigramme illustrant le principe simplifié de la méthode de reconstruction spectrale;
La figure 4 est un organigramme illustrant des étapes de traitement pour l'obtention du débit d'absorption spécifique selon l'invention;
La figure 5 est une vue schématique en perspective d'une sonde unique bipolarisée selon l'invention;
La figure 6 est une vue en coupe de la sonde bipolarisée selon l'invention;
La figure 7 est un schéma détaillé d'un exemple de réalisation d'un multiplexeur selon l'invention;
Les figures 8 et 9 sont des vues schématiques d'un dispositif de mesure selon la méthode de diffusion modulée selon l'invention.

Bien que l'invention n'y soit pas limitée, on va maintenant décrire un système et un procédé pour mesurer le débit d'absorption spécifique relatif au rayonnement émis par une antenne d'un téléphone portable au moyen d'un réseau de sondes bipolarisées.

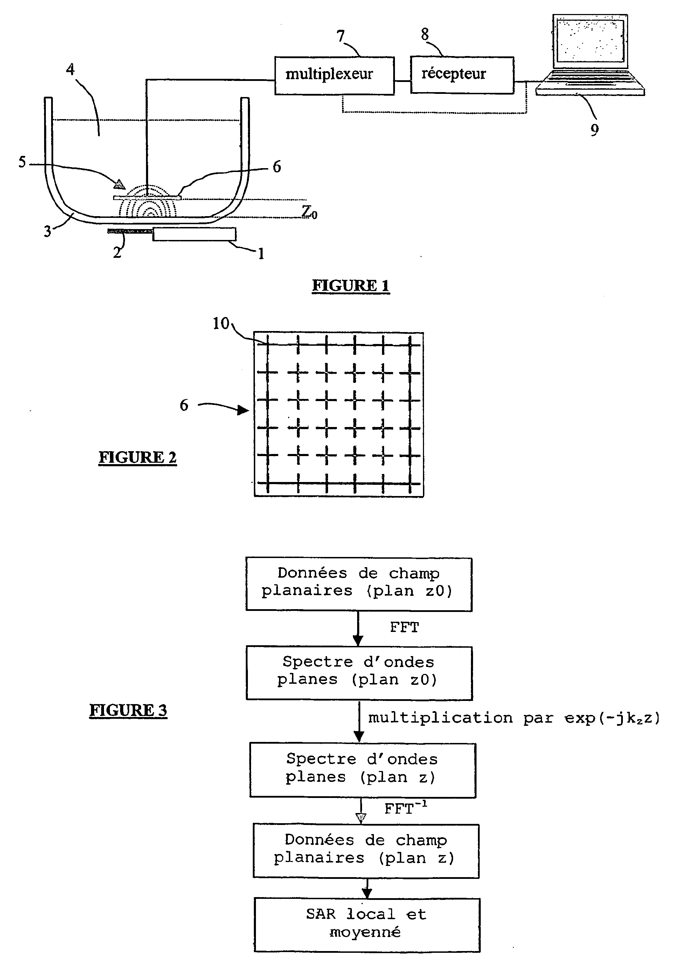

En référence à la figure 1, on distingue un fantôme générique (de type sphère tronquée) 3 contenant un liquide 4 selon la norme CENELEC prEN50361 pour la caractérisation de radio-téléphones.

Le téléphone portable 1 devant être caractérisé et disposé selon les positions normalisées sous le fantôme 3 de telle sorte que l'antenne de ce téléphone portable émet un rayonnement dans le liquide 4. Ce rayonnement, représenté dans le liquide 4 sous forme de lignes de champ sensiblement concentriques 5, crée en chaque point du liquide un champ électrique qui peut être mesuré.

Pour mesurer la répartition du champ électrique dans le volume à l'intérieur du fantôme 3, on place un réseau de sondes 6 à une distance prédéterminée Z0 typiquement sensiblement comprise entre quinze mm et vingt-cinq mm du fond du fantôme (soit par exemple 23 mm).

Comme on peut le voir sur la figure 2, le réseau de sonde 6 est constitué par un substrat rigide mince carré de 70 millimètres de coté et portant 36 sondes bipolarisées 10. L'invention est notamment remarquable par le fait qu'en utilisant des sondes bipolarisées, on mesure les deux composantes tangentielles au plan de mesure du champ électrique de façon à déterminer le champ électrique en amplitude et en phase de chacune de ces composantes.

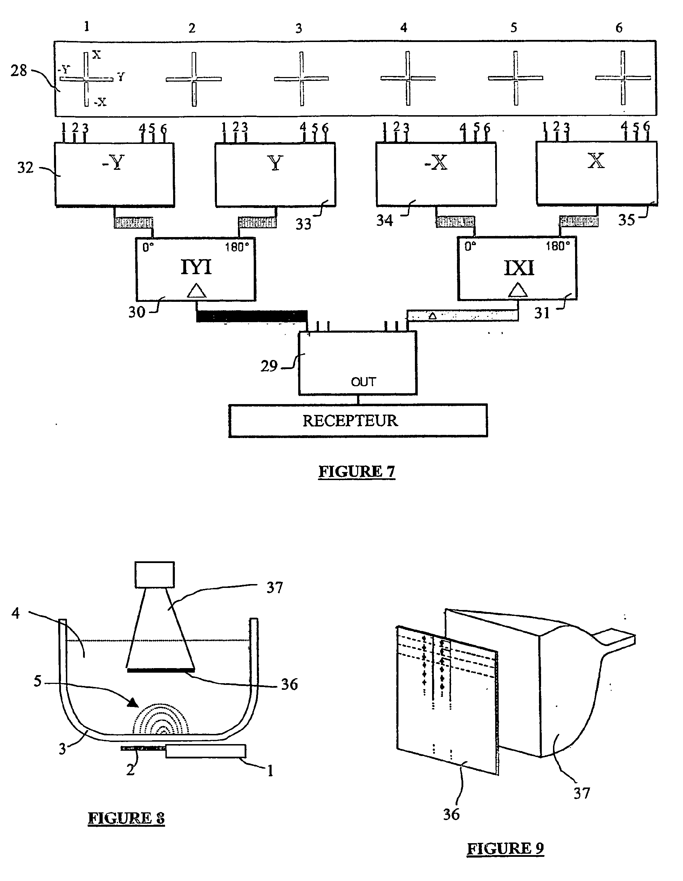

Les sondes bipolarisées 10 sont sélectionnées les unes après les autres comme on le verra plus en détail conformément à la figure 7.

Sur la figure 1, le multiplexeur 7 permet de sélectionner successivement les sondes bipolarisées 10. Les signaux récupérés à partir de ces sondes sont dirigés vers un récepteur 8 tel qu'un analyseur de réseaux (c'est à dire un voltmètre vectoriel) ou un oscilloscope, puis convertis sous forme numérique de façon à être traités par un micro ordinateur 9. Ce micro ordinateur 9 est doté de moyens logiciel et matériel pour gérer et synchroniser la mesure du champ électrique et pour calculer le débit d'absorption spécifique à partir du champ électrique.

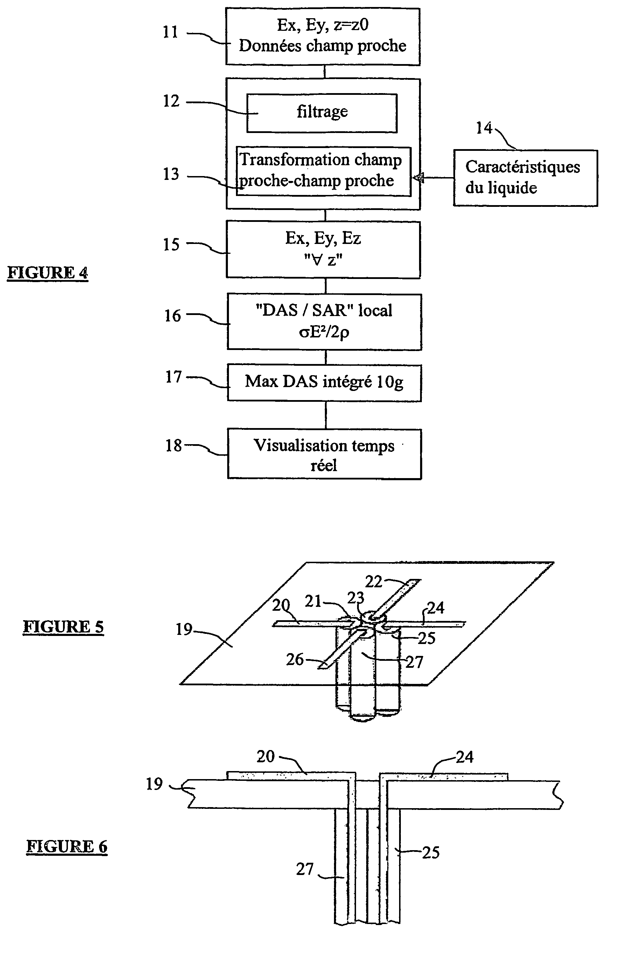

Sur la figure 3, on voit le principe simplifié de la méthode de reconstruction spectrale. On réalise une transformée de Fourier rapide pour obtenir le spectre d'ondes planes dans un plan z0 à partir de données de champ planaires (plan z0). On réalise la (Rétro)propagation : multiplication par exp(-jk_{z}z), avec z la distance de (rétro)propagation et k_{z} la composante complexe suivant z de la constante de propagation du milieu. On obtient alors le spectre d'ondes planes dans unplan z. En appliquant une transformée de Fourier rapide inverse, on détermine des données de champ planaires (plan z) à partir desquelles on calcule le SAR local et moyenné.

L'organigramme de la figure 4 illustre différentes étapes effectuées au sein du micro ordinateur 9 afin de calculer le débit d'absorption spécifique. A l'étape 11, on récupère pour chaque sonde, les deux composantes du champ électriques Ex, Ey pour Z = Z0. Ces données sont considérées comme des données de champ proche. Pour tenir compte des ondes évanescentes et limiter leur influence, on effectue un filtrage 12, notamment de type spectral circulaire.

Plus précisément, ce filtrage est réalisé au cours d'une étape 13, dans laquelle on fait subir aux données de champ proche, obtenues pour un plan Z = Z0, une transformation champ proche - champ proche de façon à déterminer le champ électrique dans tout le volume du liquide. On applique en particulier des algorithmes de Transformée de Fourier Rapide.

L'étape 13 nécessite la connaissance des caractéristiques du liquide telles que la permittivité et la conductivité, ainsi que la fréquence de travail.

A l'étape 15, on obtient le champ électrique Ex, Ey, Ez en tout point du liquide. A l'étape 16, on calcule le DAS local en utilisant la formule suivante: DAS = σ(Eₓ2 + Ey²+ E_{z}²)/ρ

A l'étape 17, selon la norme à respecter, on calcule la valeur du DAS maximum moyen caractéristique du téléphone portable. Par exemple pour la norme CENELEC prEN50361 on prend le maximum du DAS moyenné sur 10 grammes. Ensuite, à l'étape 18, on peut visualiser en temps réel sur l'écran du micro ordinateur 9 une représentation en trois dimensions du champ électrique dans le liquide du fantôme ainsi que la valeur du DAS maximum local et moyenné.

Le traitement de données au sein du micro ordinateur 9 est optimisé de façon à obtenir une quinzaine d'images par seconde et ainsi visualiser le champ électrique et le DAS en temps réel.

Sur les figures 5 et 6, on voit un peu plus en détail une sonde unique bipolarisée. Chaque sonde est constituée par 4 pistes disjointes 20, 22, 24, 26 gravées en croix sur un substrat 19 de circuit imprimé. Chaque piste de chaque dipôle est reliée (par soudure ou par collage) à l'âme centrale d'un câble coaxial fin vertical. Les deux câbles reliés aux deux pistes d'un même dipôle sont connectés aux bornes d'un symétriseur (coupleur hybride 3dB 0-180°) comme on le verra en détail ci-dessous. Une sonde bipolarisée nécessite donc deux symétriseurs distincts.

Les quatre câbles coaxiaux 21, 23, 25 et 27 sont accolés les uns aux autres pour assurer le contact entre les blindages et de telle sorte que les quatre pistes sont proches sans pour autant se toucher. De préférence, le substrat 19 de circuit imprimé est choisi de telle sorte que sa permittivité est proche de celle du liquide dans lequel il va être plongé. Contrairement aux systèmes de l'art antérieur dans lesquels, grâce à une sonde détectée isotrope, on récupérait uniquement l'amplitude du champ électrique sous forme d'une tension, les sondes bipolarisées selon l'invention permettent de mesurer un signal micro-onde renfermant l'amplitude et la phase de deux des composantes du champ électrique.

Pour récupérer les données de chaque sonde, on réalise un balayage électronique dont un mode de réalisation est représenté sur la figure 7. Pour une compréhension plus aisée, on considère un réseau 28 constitué de 6 sondes bipolarisées. Chaque sonde comporte quatre pistes identifiées par les éléments X, -X, Y et -Y. Le multiplexeur 7 comprend un commutateur 29 qui transmet à chaque instant un signal provenant d'une piste X, -X, Y ou -Y vers l'analyseur de réseaux 8. Ce commutateur 29 comprend une première entrée reliée à un premier symétriseur 30 (coupleur hybride 0-180°) symbolisé par la valeur absolue de Y et une seconde entrée reliée à un second symétriseur 31 symbolisé par la valeur absolue de X. Chaque symétriseur est doté de deux entrées, une première entrée à 0 degré et une seconde entrée déphasée de 180 degrés. Le symétriseur 30 est connecté par sa première entrée 0 degré à un commutateur 32 (-Y). La seconde entrée 180 degrés du symétriseur 30 est reliée à un commutateur 33 (Y). Le commutateur 32 comporte 6 entrées, chacune reliée à la piste -Y de chaque sonde bipolarisée. De même le commutateur 33 comporte 6 entrées, chacune reliée à la piste Y de chaque sonde bipolarisée.

De même le symétriseur 31 est relié par sa première entrée 0 degré à un commutateur 34 (-X), et par sa seconde entrée 180 degrés à un commutateur 35 (X). le commutateur 34 comporte 6 entrées chacune reliée à la piste -X de chaque sonde bipolarisée. De même, le commutateur 35 comporte 6 entrées, chacune reliée à la piste X de chaque sonde bipolarisée.

Tous les commutateurs sont pilotés par le micro ordinateur 9 en synchronisation avec l'acquisition des données par l'analyseur de réseaux 8.

Bien sûr, l'invention n'est pas limitée aux exemples qui viennent d'être décrits et de nombreux aménagements peuvent être apportés à ces exemples sans sortir du cadre de l'invention. On peut notamment envisager la mesure du champ électrique en utilisant la méthode de diffusion modulée conformément aux figures 8 et 9. Pour ce faire, on utilise une rétine 36 associée à un collecteur 37. Le collecteur est ensuite relié à un système récepteur de traitement de données. La rétine est constituée par un panneau diélectrique portant en réseau plusieurs dipôles chargés par des diodes (modulation électrique). Chaque diode peut être adressée au moyen de câbles électriques de polarisation spécifiée par ligne et colonne. Par adressage ligne-colonne, la diode d'un dipôle peut être modulée. Le signal disponible à l'entrée du collecteur est alors proportionnel au champ à l'emplacement de ce dipôle. Avec un tel système, les diodes sont modulées en basse fréquence à environ quelques 100 kHertz.

Pour réduire les risques d'interaction entre les câbles d'adressage de modulation, on peut envisager d'utiliser une modulation optique des dipôles chargés alors par des éléments photo-sensibles. La modulation de ces éléments photo-sensibles ou d'un faisceau laser s'effectue alors par l'intermédiaire de fibres optiques, très peu perturbateurs aux fréquences micro-ondes.

## Revendications

1. Procédé pour mesurer un Débit d'Absorption Spécifique DAS dans un fantôme (3) rempli d'un liquide (4) reconstituant les propriétés diélectriques d'un tissu biologique, ce fantôme étant exposé- à une émission micro-onde provenant d'une antenne (2), ce procédé est défini en ce que:
- on mesure le champ électrique en amplitude et en phase à l'intérieur du fantôme, pour une pluralité de points s'inscrivant sur une surface donnée définie dans une zone de champ proche de concentration dudit champ électrique; et est **caractérisé en ce que**:
- on réalise une transformation champ proche-champ proche à partir des données mesurées sur cette surface de façon à déterminer le champ électrique dans le volume à l'intérieur du fantôme; et
- on calcule la valeur du DAS.

2. Procédé selon la revendication 1, **caractérisé en ce qu'**on mesure le champ électrique en utilisant au moins une sonde apte à mesurer deux composantes tangentielles, à ladite surface, du champ électrique en chaque point de mesure; la composante normale étant déduite par calcul à partir des deux composantes tangentielles sur ladite surface.

3. Procédé selon la revendication 1 ou 2, **caractérisé en ce qu'**on réalise la transformation champ proche-champ proche en utilisant un algorithme de développement en sommes d'ondes planes.

4. Procédé selon la revendication 3, **caractérisé en ce que** ledit algorithme, prenant en compte les pertes dans le liquide, utilise des transformées de Fourier Rapides.

5. Procédé selon l'une quelconque des revendications précédentes, **caractérisé en ce que**, au cours de la transformation champ proche-champ proche, on réalise un filtrage de façon à limiter des effets de remontée de bruit dus aux ondes évanescentes.

6. Procédé selon l'une quelconque des revendications précédentes, **caractérisé en ce qu'**on mesure le champ électrique au moyen d'une pluralité de sondes disposées en réseau de telle sorte qu'on réalise des mesures rapides, en temps réel.

7. Procédé selon la revendication 6, **caractérisé en ce qu'**on visualise en temps réel sur un écran de visualisation la valeur du champ électrique et du DAS.

8. Procédé selon la revendication 6 ou 7, **caractérisé en ce qu'**on utilise des sondes bipolarisées de façon à mesurer deux composantes tangentielles, à ladite surface, du champ électrique en chaque point de mesure et en déduire l'amplitude et la phase; la composante normale étant déduite par calcul à partir des deux composantes tangentielles.

9. Procédé selon l'une quelconque des revendications précédentes, **caractérisé en ce que** ladite surface se situe sensiblement à une distance optimale de quinze à vingt-cinq millimètres de la paroi interne du fantôme.

10. Système pour mesurer un Débit d'Absorption Spécifique DAS dans un fantôme (3) rempli d'un liquide (4) reconstituant les propriétés diélectriques d'un tissu biologique, ce fantôme étant exposé à une émission micro-onde provenant d'une antenne (2); ce système comprend:
- des moyens (6) pour mesurer le champ électrique en amplitude et en phase, à l'intérieur du fantôme, pour une pluralité de points (10) s'inscrivant sur une surface donnée définie dans une zone de champ proche de concentration dudit champ électrique; et est **caractérisé en ce qu'**il comprend également :
- des moyens de traitement (9) pour réaliser une transformation champ proche-champ proche à partir des données mesurées sur cette surface de façon à déterminer le champ électrique dans le volume à l'intérieur du fantôme, et pour calculer la valeur du DAS.

11. Système selon la revendication 10, **caractérisé en ce que** les moyens de mesure du champ électrique en amplitude et en phase comprennent un réseau de sondes bipolarisées apte à mesurer deux composantes tangentielles, à ladite surface, du champ électrique en chaque point de mesure; la composante normale étant déduite par calcul à partir des deux composantes tangentielles.

12. Système selon la revendication 11, **caractérisé en ce que** chaque sonde comporte deux dipôles électriques orthogonaux constitués par quatre pistes distinctes conductrices coplanaires fixées en forme de croix sur un substrat mince et rigide.

13. Système selon la revendication 11 ou 12, **caractérisé en ce que** le réseau de sondes est un réseau plan parallèle à la paroi du fantôme d'où provient le signal micro-onde.

14. Système selon la revendication 11 ou 12, **caractérisé en ce que** le réseau de sondes est un réseau dont la forme imite la forme du côté du fantôme exposé au signal micro-onde.

15. Système selon l'une quelconque des revendications 11 à 14, **caractérisé en ce que** les moyens de traitement comprennent:
- un multiplexeur pour piloter successivement chaque sonde,
- un analyseur de réseaux pour recevoir les signaux micro-ondes provenant des sondes, et
- un module de traitement tel qu'un micro-ordinateur pour réaliser la transformation champ proche-champ proche, calculer le DAS et piloter le multiplexeur et l'analyseur de réseau.

16. Système selon la revendication 15, **caractérisé en ce que** le multiplexeur comprend, disposés en cascade, et pour une rangée de six sondes :
- un premier commutateur pour sélectionner successivement les deux polarisations horizontale et verticale des sondes, dont les entrées sont reliées à deux symétriseurs,
- quatre autres commutateurs pour sélectionner l'une des six sondes, chaque commutateur étant affecté à l'une des quatre pistes des sondes, chaque entrée de chaque commutateur étant relié à chacune des six sondes, et les quatre sorties des commutateurs étant reliées deux à deux aux entrées des symétriseurs.

17. Système selon la revendication 15, **caractérisé en ce que** le multiplexeur consiste en un circuit électronique composé de commutateurs microondes intégrés montés en surface (CMS).

18. Système selon l'une quelconque des revendications 11 à 17, **caractérisé en ce que** les sondes sont constituées en un réseau plan carré de côté sensiblement égal à soixante-dix millimètres dans le cas de la mesure du DAS de téléphones portables.

19. Système selon l'une quelconque des revendications 11 à 18, **caractérisé en ce que**, les sondes étant constituées en réseau, la distance entre deux sondes est au plus égale à la moitié de la longueur d'onde du signal micro-onde émis.

20. Système selon l'une quelconque des revendications 11 à 19, **caractérisé en ce que**, les sondes étant constituées en réseau, la distance entre le réseau de sondes et la paroi du fantôme exposé au signal micro-onde est typiquement sensiblement comprise entre quinze millimètres et vingt-cinq millimètres, selon la bande de fréquences considérée.

21. Système selon l'une quelconque des revendications 11 à 20, **caractérisé en ce que** les sondes sont constituées en un réseau de trente-six sondes.

22. Système selon la revendication 10, **caractérisé en ce que** les moyens de mesure comprennent un réseau de dipôles associé à un collecteur selon une méthode de diffusion modulée, chaque dipôle étant chargé par une diode qui, lorsqu'elle est modulée, diffuse vers le collecteur un signal proportionnel au champ électrique à l'emplacement du dipôle associé.

## Claims

1. Method for measuring a Specific Absorption Rate SAR in a phantom (3) filled with a liquid (4) reconstituting the dielectric properties of a biological tissue, this phantom being exposed to a microwave transmission originating from an antenna (2), this method is defined in that:
- the electric field is measured by amplitude and by phase inside the phantom, for a plurality of points arranged on a given surface defined in a near field concentration zone of said electric field; and is **characterized in that**
- a near-field to near-field transformation is carried out from the data measured on this surface in order to determine the electric field in the volume inside the phantom; and
- the value of the SAR is calculated.

2. Method according to claim 1, **characterized in that** the electric field is measured using at least one probe which is able to measure two components, which are tangential to said surface, of the electric field at each measurement point; the normal component being deduced by calculation using the two tangential components on said surface.

3. Method according to claim 1 or 2, **characterized in that** the near-field to near-field transformation is carried out using an enumeration algorithm by the summation of plane waves.

4. Method according to claim 3, **characterized in that** said algorithm, taking account of the losses in the liquid, uses fast Fourier transforms.

5. Method according to any one of the preceding claims, **characterized in that**, during the near-field to near-field transformation, a filtering is carried out in order to limit the effects of noise feedback due to evanescent waves.

6. Method according to any one of the preceding claims, **characterized in that** the electric field is measured using a plurality of probes arranged in an array so that rapid measurements are carried out, in real time.

7. Method according to claim 6, **characterized in that** the value of the electric field and the SAR is displayed in real time on a display screen.

8. Method according to claim 6 or 7, **characterized in that** dual-polarized probes are used in order to measure two components, which are tangential to said surface, of the electric field at each measurement point and to deduce therefrom the amplitude and the phase; the normal component being deduced by calculation from the two tangential components.

9. Method according to any one of the preceding claims, **characterized in that** said surface is situated approximately at an optimal distance of fifteen to twenty five millimetres from the inside wall of the phantom.

10. System for measuring a Specific Absorption Rate SAR in a phantom (3) filled with a liquid (4) reconstituting the dielectric properties of a biological tissue, this phantom being exposed to a microwave transmission originating from an antenna (2), this system comprises:
- means (6) for measuring the electric field by amplitude and by phase, inside the phantom, for a plurality of points (10) arranged on a given surface defined in a near field concentration zone of said electric field; and is **characterized in that** it also comprises:
- processing means (9) for carrying out a near-field to near-field transformation using the data measured on this surface in order to determine the electric field in the volume inside the phantom, and in order to calculate the SAR value.

11. System according to claim 10, **characterized in that** the means for measuring the electric field by amplitude and by phase comprise an array of dual-polarized probes which are able to measure two components, which are tangential to said surface, of the electric field at each measurement point; the normal component being deduced by calculation from the two tangential components.

12. System according to claim 11, **characterized in that** each probe comprises two orthogonal electric dipoles constituted by four distinct and coplanar conductive tracks fixed in the form of a cross on a thin and rigid substrate.

13. System according to claim 11 or 12, **characterized in that** the array of probes is a flat array parallel to the wall of the phantom from where the microwave signal originates.

14. System according to claim 11 or 12, **characterized in that** the array of probes is an array, the shape of which imitates the shape of the side of the phantom exposed to the microwave signal.

15. System according to any one of claims 11 to 14, **characterized in that** the processing means comprise:
- a multiplexer for successively controlling each probe,
- an array analyzer for receiving the microwave signals originating from the probes, and
- a processing module such as a microcomputer for carrying out the near-field to near-field transformation, calculating the SAR and controlling the multiplexer and the array analyzer.

16. System according to claim 15, **characterized in that** the multiplexer comprises, arranged in cascade, and for a row of six probes:
- a first switch for successively selecting the two horizontal and vertical polarizations of the probes, the inputs of which are connected to two baluns,
- four other switches for selecting one of the six probes, each switch being assigned to one of the four tracks of the probes, each input of each switch being connected to each of the six probes, and the four outputs of the switches being connected two-by-two to the inputs of the baluns.

17. System according to claim 15, **characterized in that** the multiplexer consists of an electronic circuit composed of integrated microwave switches which are surface-mounted (SMC).

18. System according to any one of claims 11 to 17, **characterized in that** the probes are constituted by a square flat array with a side approximately equal to seventy millimetres in the case of the measurement of the SAR of mobile telephones.

19. System according to any one of claims 11 to 18, **characterized in that**, the probes being constituted in an array, the distance between two probes is at most equal to half of the wavelength of the microwave signal transmitted.

20. System according to any one of claims 11 to 19, **characterized in that**, the probes being constituted in an array, the distance between the array of probes and the wall of the phantom exposed to the microwave signal is typically approximately comprised between fifteen millimetres and twenty five millimetres, according to the frequency band considered.

21. System according to any one of claims 11 to 20, **characterized in that** the probes are constituted in an array of thirty six probes.

22. System according to claim 10, **characterized in that** the measurement means comprise an array of dipoles associated with a collector according to a modulated scatter method, each dipole being charged by a diode which, when it is modulated, scatters a signal proportional to the electric field at the location of the associated dipole to the collector.

## Patentansprüche

1. Verfahren zum Messen einer Spezifischen Absorptionsrate SAR in einem Phantom (3), das mit einer Flüssigkeit (4) gefüllt ist, die die dielektrischen Eigenschaften eines biologischen Gewebes wiedergibt, wobei dieses Phantom einer von einer Antenne (2) kommenden Mikrowellenemission ausgesetzt ist, wobei dieses Verfahren **dadurch** definiert ist, dass:
- man das elektrische Feld in Amplitude und in Phase im Inneren des Phantoms an einer Vielzahl von Punkten misst, die in eine gegebene Fläche eingeschrieben sind, die in einer Nahfeldzone der Konzentration dieses elektrischen Felds definiert ist;
und **dadurch gekennzeichnet ist, dass**:
- man eine Nahfeld-Nahfeld-Transformation ausgehend von den auf dieser Fläche gemessenen Daten ausführt, so dass das elektrische Feld in dem Volumen im Inneren des Phantoms bestimmt wird; und
- man den Wert der SAR berechnet.

2. Verfahren nach Anspruch 1, **dadurch gekennzeichnet, dass** man das elektrische Feld misst, indem man mindestens eine Sonde verwendet, die in der Lage ist, zwei zu dieser Fläche tangentiale Komponenten des elektrischen Felds an jedem Meßpunkt zu messen; wobei die normale Komponente aus den beiden zu dieser Fläche tangentialen Komponenten durch Berechnung abgeleitet wird.

3. Verfahren nach Anspruch 1 oder 2, **dadurch gekennzeichnet, dass** man die Nahfeld-Nahfeld-Transformation ausführt, indem man einen Algorithmus der Entwicklung in Summen von ebenen Wellen verwendet.

4. Verfahren nach Anspruch 3, **dadurch gekennzeichnet, dass** der Algorithmus in Berücksichtigung der Verluste in der Flüssigkeit schnelle Fourier-Transformierte verwendet.

5. Verfahren nach einem der vorhergehenden Ansprüche, **dadurch gekennzeichnet, dass** man im Lauf der Nahfeld-Nahfeld-Transformation eine Filterung vornimmt, so dass durch die abklingenden Wellen verursachte Geräuschanstiegswirkungen begrenzt werden.

6. Verfahren nach einem der vorhergehenden Ansprüche, **dadurch gekennzeichnet, dass** man das elektrische Feld mit Hilfe einer Vielzahl von in einem Gitter angeordneten Sonden misst, so dass man schnelle Messungen in Echtzeit ausführt.

7. Verfahren nach Anspruch 6, **dadurch gekennzeichnet, dass** man den Wert des elektrischen Felds und der SAR auf einem Bildschirm in Echtzeit visualisiert.

8. Verfahren nach Anspruch 6 oder 7, **dadurch gekennzeichnet, dass** man bipolarisierte Sonden so verwendet, dass zwei zu dieser Fläche tangentiale Komponenten des elektrischen Felds an jedem Messpunkt gemessen werden und davon die Amplitude und die Phase abgeleitet werden, wobei die normale Komponente aus den beiden tangentialen Komponenten durch Berechnung abgeleitet wird.

9. Verfahren nach einem der vorhergehenden Ansprüche, **dadurch gekennzeichnet, dass** diese Fläche im Wesentlichen in einem optimalen Abstand von fünfzehn bis fünfundzwanzig Millimetern von der Innenwand des Phantoms entfernt liegt.

10. System zum Messen einer Spezifischen Absorptionsrate SAR in einem Phantom (3), das mit einer Flüssigkeit (4) gefüllt ist, die die dielektrischen Eigenschaften eines biologischen Gewebes wiedergibt, wobei dieses Phantom einer von einer Antenne (2) kommenden Mikrowellenemission ausgesetzt ist, wobei dieses System umfasst:
- Mittel (6) zum Messen des elektrischen Felds in Amplitude und in Phase im Inneren des Phantoms an einer Vielzahl von Punkten (10), die in eine gegebene Fläche eingeschrieben sind, die in einer Nahfeldzone der Konzentration dieses elektrischen Felds definiert ist;
und **dadurch gekennzeichnet ist, dass** es ferner umfasst:
- Verarbeitungsmittel (9) zum Durchführen einer Nahfeld-Nahfeld-Transformation aus auf dieser Fläche gemessenen Daten, so dass das elektrische Feld in dem Volumen im Inneren des Phantoms bestimmt wird, und zum Berechnen des Werts des DAS.

11. System nach Anspruch 10, **dadurch gekennzeichnet, dass** die Mittel zum Messen des elektrischen Felds in Amplitude und in Phase ein Gitter von bipolarisierten Sonden umfassen, das in der Lage ist, zwei zu dieser Fläche tangentiale Komponenten des elektrischen Felds in jedem Messpunkt zu messen; wobei die normale Komponente aus den beiden tangentialen Komponenten durch Berechnung abgeleitet wird.

12. System nach Anspruch 11, **dadurch gekennzeichnet, dass** die Sonde zwei orthogonale elektrische Dipole umfasst, die aus vier verschiedenen koplanaren leitenden Bahnen bestehen, die kreuzförmig auf einem dünnen und starren Substrat befestigt sind.

13. System nach Anspruch 11 oder 12, **dadurch gekennzeichnet, dass** das Sondengitter ein ebenes Gitter ist, das zu der Wand des Phantoms parallel ist, von der das Mikrowellensignal kommt.

14. System nach Anspruch 11 oder 12, **dadurch gekennzeichnet, dass** das Sondengitter ein Gitter ist, dessen Form die Form der Seite des Phantoms nachahmt, die dem Mikrowellensignal ausgesetzt ist.

15. System nach einem der Ansprüche 11 bis 14, **dadurch gekennzeichnet, dass** die Verarbeitungsmittel umfassen:
- einen Multiplexierer zum Steuern nacheinander jeder Sonde,
- einen Netzanalysierer zum Empfangen der von den Sonden kommenden Mikrowellensignale, und
- ein Verarbeitungsmodul wie einen Mikrorechner zum Durchführen der Nahfeld-Nahfeld-Transformation, Berechnen der SAR und Steuern des Multiplexierers und des Netzanalysierers.

16. System nach Anspruch 15, **dadurch gekennzeichnet, dass** der Multiplexierer, als Kaskade angeordnet und für eine Reihe von sechs Sonden, umfasst:
- einen ersten Schalter zum Wählen der beiden Polarisationen horizontal und vertikal der Sonden nacheinander, deren Eingänge mit zwei Symmetrisierern verbunden sind,
- vier weitere Schalter zum Wählen einer der sechs Sonden, wobei jeder Schalter einer der vier Bahnen der Sonde zugeteilt ist, wobei jeder Eingang jedes Schalters mit jedem der sechs Sonden verbunden ist, und die vier Ausgänge der Schalter paarweise mit den Eingängen der Symmetrisierer verbunden sind.

17. System nach Anspruch 15, **dadurch gekennzeichnet, dass** der Multiplexierer in einer elektronischen Schaltung besteht, die aus oberflächenmontierten (SMD) integrierten Mikrowellen-Schaltern besteht.

18. System nach einem der Ansprüche 11 bis 17, **dadurch gekennzeichnet, dass** die Sonden aus einem ebenen quadratischen Gitter, im Fall der Messung der SAR von tragbaren Telefonen, mit einer Seitenlänge von im Wesentlichen gleich siebzig Millimeter bestehen.

19. System nach einem der Ansprüche 11 bis 18, **dadurch gekennzeichnet, dass**, wenn die Sonden in einem Gitter gebildet sind, der Abstand zwischen zwei Sonden höchstens gleich der Hälfte der Wellenlänge des gesendeten Mikrowellensignals ist.

20. System nach einem der Ansprüche 11 bis 19, **dadurch gekennzeichnet, dass**, wenn die Sonden in einem Gitter gebildet sind, der Abstand zwischen dem Sondengitter und der dem Mikrowellensignal ausgesetzten Wand des Phantoms, je nach dem betreffenden Frequenzband, typischerweise im Wesentlichen zwischen fünfzehn Millimeter und fünfundzwanzig Millimeter beträgt.

21. System nach einem der Ansprüche 11 bis 20, **dadurch gekennzeichnet, dass** die Sonden in einem Gitter aus sechsunddreißig Sonden gebildet sind.

22. System nach Anspruch 10, **dadurch gekennzeichnet, dass** die Messmittel ein Gitter von Dipolen umfassen, dem ein Kollektor gemäß einer Methode der modulierten Verbreitung zugeordnet ist, wobei jeder Dipol durch eine Diode belastet ist, die, wenn sie moduliert wird, zum Kollektor ein Signal verbreitet, das zu dem elektrischen Feld an der Stelle des zugeordneten Dipols proportional ist.
